# DEMANDE DE BREVET EUROPEEN

(11) **EP 2 056 071 A2**
(43) Date de publication de la demande: **06.05.2009**
(21) Numéro de dépôt: 08105694.7
(22) Date de dépôt: 29.10.2008
(51) Int. Cl.: G01D 5/347

(54) **Procédé de numérisation d'un signal quelconque**

(30) Priorité: 30.10.2007 FR 0707619
(71) Demandeur: Valeo Systèmes Thermiques, 78321 Le Mesnil St Denis Cedex (FR)
(72) Inventeur: HUYNH, Tan Duc, 93330, Neuilly sur Marne (FR)
(74) Mandataire: Croonenbroek, Thomas Jakob

(57) **Abrégé**

Procédé de numérisation d'un signal comprenant un cycle composé d'au moins les étapes suivantes prises successivement :
a. acquisition (21) d'au moins un signal (S(t)) ;
b. mesure d'une amplitude maximum (Vmax(T_{¡})) et d'une amplitude minimum (Vmin(T_{¡})) du signal (S(t)) sur une période (Tᵢ) du signal (S(t));
c. détermination d'une valeur seuil (s(Tᵢ)) sur une période (Tᵢ) du signal (S(t)) en fonction desdites amplitudes (Vmax(T_{¡}) et (Vmin(T_{¡})) mesurées ;
d. comparaison (22) du signal (S(t)) avec le seuil (ε(T_{¡})) sur une période (Tᵢ₊₁) du signal (S(t)) ;
e. conversion (23) de toutes les valeurs du signal (S(t)) inférieures au seuil (ε(Tᵢ)) en un niveau logique « 0 » et de toutes les valeurs du signal (S(t)) supérieures ou égales au seuil (ε(Tᵢ₋₁)) en un niveau logique « 1 ».

## Description

### Domaine technique de l'invention

La présente invention concerne un procédé de numérisation d'un signal analogique permettant de détecter le seuil de basculement d'un signal analogique et un dispositif équipé d'un tel procédé. Cette méthode est idéalement mise en oeuvre dans des moyens d'encodage pouvant notamment être montés sur les tableaux de commande, en particulier dans des véhicules automobiles.

### État de la technique

Parmi les moyens de traitements de signal délivrant des signaux numérisés, les moyens d'encodage sont des dispositifs connus. Notamment, des codeurs rotatifs, en particulier à commande optique ou électromécaniques, sont des moyens d'encodage simples à mettre en oeuvre. Ces capteurs fournissent des informations sur le déplacement, la position ou la vitesse d'un système tel qu'un bouton rotatif de commande. Le signal numérique délivré en sortie d'un codeur rotatif est donc une fonction mathématique de la position angulaire d'un axe d'entrée. Ces codeurs rotatifs se doivent d'être toujours plus précis, tout en exigeant une résolution de plus en plus fine et des forces de frottements nulles afin de répondre aux demandes du marché.

On connaît déjà, en particulier d'après la publication EP 1 526 644 un codeur optique rotatif.

Un tel dispositif requiert une résolution suffisante qui, lorsqu'elle est trop fine, entraîne des interférences entre les signaux et ne permet pas de restituer correctement l'information lumineuse. Cela se manifeste généralement, en sortie du dispositif de codage, par la déformation d'un signal saturé normalement carré, en un signal sinusoïdal.

Des dispositifs complexes permettent de corriger l'interférence des signaux lumineux à l'origine de ce problème et d'améliorer la qualité du signal carré en sortie du dispositif de codage, tout en augmentant la résolution des codeurs. Certains codeurs rotatifs optiques intègrent des guides de lumière qui sont placés sur des récepteurs optiques des codeurs et qui permettent d'amplifier ou d'étendre la portée du signal généré par les récepteurs. Un dispositif de ce type est décrit dans la publication US 2004 113058.

Néanmoins, de tels systèmes de codage sont des systèmes de détection complexes, plus encombrant et qui sont onéreux à fabriquer puisqu'ils nécessitent des guides de lumières supplémentaires.

La présente invention a pour but de résoudre les problèmes techniques cités précédemment.

La présente invention est un procédé de numérisation de signaux électriques quelconques, simple à mettre en oeuvre et qui évite toute détérioration des signaux. Lorsque le moyen de numérisation utilisé est un moyen de codage et en particulier un codeur incrémental, ce procédé permet d'obtenir en sortie du codeur un signal parfaitement numérisé, quelque soit la résolution du codeur.

### Objet de l'invention

Plus précisément, l'invention se rapporte à un procédé de numérisation d'un signal comprenant un cycle composé d'au moins les étapes suivantes prises successivement :
a. l'acquisition d'au moins un signal S(t) ;
b. l'acquisition ou détermination d'une valeur seuil ε(Tᵢ) sur une période Tᵢ du signal S (t) ;
c. la comparaison du signal S(t) avec le seuil ε(Tᵢ) sur une période Tᵢ₊₁ du signal S(t) ;
d. la conversion de toutes les valeurs du signal S(t) inférieures au seuil ε(Tᵢ) en un niveau logique « 0 » et de toutes les valeurs du signal S(t) supérieures
ou égales au seuil ε(Tᵢ₋₁) en un niveau logique « 1 ». Les étapes a, b et c permettent au procédé de travailler de manière dynamique avec des données actualisées à la même fréquence que la fréquence du signal S(t) traité.
L'étape d quant à elle est la phase de numérisation du signal, le coeur même de ce procédé de numérisation puisque c'est au cours de cette étape que toutes les amplitudes du signal analogiques sont ramenées à un état logique haut ou au contraire à un état bas, créant ainsi un signal numérique.

Les amplitudes maximum Vmax(Tᵢ) et minimum Vmin(Tᵢ) du signal S(t) sont mesurées sur une période Tᵢ du signal S(t). Cette mesure est essentielle pour pouvoir comparer le seuil ε au signal S(t) à la même fréquence que la fréquence de S(t).

Dans un mode de réalisation préféré, la valeur du seuil ε(Tᵢ) est fonction des amplitudes Vmax(Tᵢ) et Vmin(Tᵢ) et stockées en mémoire et le seuil ε(Tᵢ) est recalibré dynamiquement, à une fréquence f, durant tout le cycle de fonctionnement à partir des valeurs actualisées des amplitudes Vmax(Tᵢ) et Vmin(Tᵢ). Ce mode de fonctionnement préféré permet de travailler en temps réel et de manière dynamique avec des données actualisées à la même fréquence que la fréquence de du signal S(t) traité.

En outre, un tel procédé peut être mis en oeuvre dans un dispositif de numérisation d'un signal destiné à être placé immédiatement après au moins un générateur de signal électrique comprenant :
a. des moyens d'acquisition d'au moins un signal S(t) ;
b. des moyens de mesure d'une amplitude maximum Vmax(Tᵢ) et d'une amplitude minimum Vmin(Tᵢ) du signal S(t) sur une période Tᵢ du signal S(t);
c. des moyens de détermination d'une valeur seuil ε(Tᵢ) sur une période Tᵢ du signal S(t)en fonction desdites amplitudes (Vmax(Tᵢ))et (Vmin(Tᵢ))mesurées ;
d. des moyens de comparaison du signal S(t) avec le seuil ε(Tᵢ) sur une période Tᵢ₊₁ du signal S(t) ;
e. des moyens de conversion de toutes les valeurs du signal S(t) inférieures au seuil ε(Tᵢ) en un niveau logique « 0 » et de toutes les valeurs du signal S(t) supérieures ou égales au seuil ε(Tᵢ) en un niveau logique « 1 ».
Les moyens mis en oeuvre dans les étapes a à d font du système un système dynamique dont la fréquence de fonctionnement est la même que la fréquence du signal S(t) traité.
Le moyen mis en oeuvre dans l'étape d est le coeur même du système de numérisation puisque c'est grâce à lui que le signal analogique S(t) est converti en un signal numérique S'(t).

Le signal S(t) est notamment délivré par un générateur de signaux électriques. Dans un mode de réalisation privilégié, le signal S(t) est délivré par un moyen d'encodage et en particulier par au moins un encodeur optique rotatif.

Par la suite, le signal S'(t) obtenu à l'issue de l'étape de traitement par des moyens de conversion, est avantageusement traité dans une mémoire du type microcontrôleur.

Dans un mode de réalisation la valeur du seuil ε(Tᵢ) est stockée dans une mémoire accessible en lecture. Ce mode de réalisation est le plus simple et le moins coûteux.

Dans un mode de réalisation préférée, la valeur du seuil ε(Tᵢ) est stockée dans une mémoire accessible en écriture de type EEPROM. L'avantage de ce mode de réalisation préféré est la sauvegarde de la dernière valeur du seuil ε(Tᵢ) actualisé lors de chaque mise hors tension du dispositif.

Dans la pratique, un programme d'ordinateur réalisant le procédé de numérisation d'un signal est exécuté par un microcontrôleur implémenté au sein d'un dispositif de numérisation.

Le dispositif de numérisation d'un signal peut notamment être mis en oeuvre dans un dispositif d'encodage traitant au moins deux signaux quelconque S(t) et S'(t) servant à déterminer une vitesse et/ou une position et/ou un sens de rotation sont traités au moyen du dispositif de numérisation.

Le dispositif d'encodage peut comporter un codeur optique à émission et réception de lumière comportant :
- une partie mobile en rotation (2), et
- une partie fixe comprenant au moins deux capteurs photoélectriques comportant chacun :
   - un émetteur de lumière (4) formant un faisceau lumineux incident (5) en direction de la partie mobile (2), et
   - un récepteur optique pour intercepter les faisceaux lumineux réfléchis par la partie mobile (2).

Avantageusement, un tableau de commande d'un véhicule comprend un dispositif d'encodage du type mentionné précédemment.

D'autres caractéristiques, détails et avantages de l'invention ressortiront à la lecture de la description qui suit, faite en référence aux dessins annexés donnés à titre d'exemple et qui représentent successivement :
- les figures 1a, 1b et 2a, 2b, des vues schématiques en coupe d'un bouton rotatif et les signaux émis par le circuit de traitement numérique en sortie, en fonction de la résolution du codeur, dans le cas de l'état antérieur de la technique,
- la figure 3, un logigramme détaillant les différentes étapes du procédé de numérisation d'un signal électrique selon la présente invention,
- la figure 4, une vue schématique du dispositif de numérisation d'un signal électrique fonctionnant suivant le procédé décrit,
- les figures 5a et 5b, une représentation graphique des signaux électriques avant et après le traitement par le dispositif de l'invention,

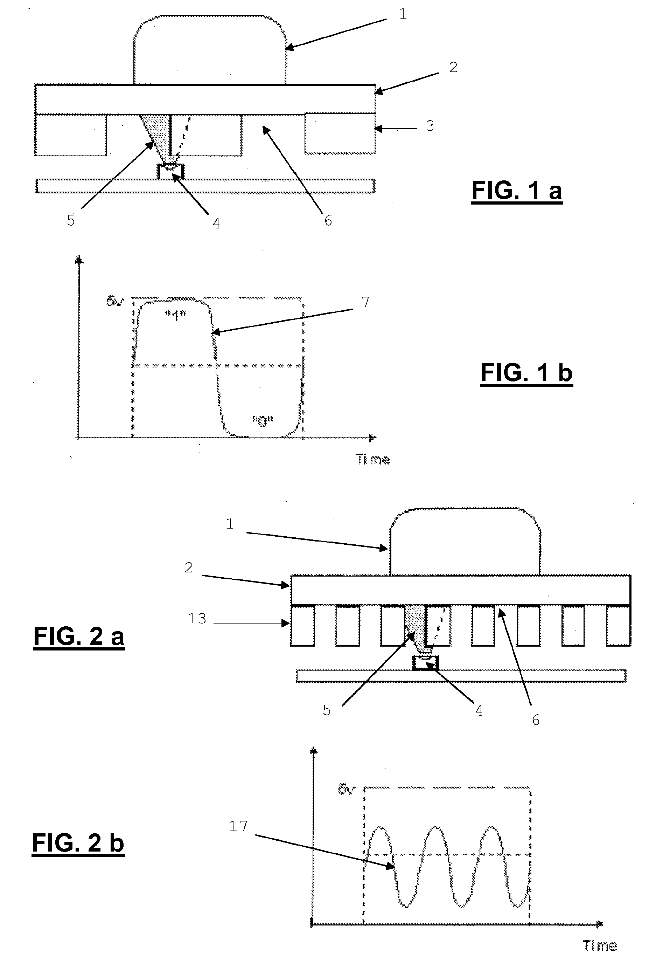

Les figures 1a et 2a représentent chacune un bouton rotatif (1) dans l'état antérieur de la technique, la résolution du bouton rotatif représenté sur la figure 2a est néanmoins plus fine que la résolution du bouton rotatif représenté sur la figure 1a. Les figures 1b et 2b représentent les signaux obtenus en sortie des circuits de traitement numérique respectifs.

Un bouton rotatif (1) tel que représenté en figure 1a est constitué d'une couronne (2) divisée en 'm' parties saillantes (3) régulièrement espacées, constituant une partie mobile en rotation et de deux capteurs photoélectriques décalés angulairement comprenant chacun un émetteur de lumière (4) formant un faisceau lumineux incident (5) et un récepteur optique, non représenté sur les figures 1a et 2a, pour intercepter les faisceaux réfléchis par la partie mobile, décalés radialement et/ou angulairement l'un par rapport à l'autre.

En fonctionnement normal, comme c'est le cas sur les figures 1a et 1b, un premier faisceau lumineux incident (5) est délivré par l'émetteur (4) du capteur en direction de la surface interne de la couronne (2). Selon que ce faisceau incident (5) frappe on non une partie saillante (3), un deuxième faisceau lumineux (non représenté sur la figure 1a) est réfléchi avec un angle tel qu'il est intercepté ou non par le récepteur optique, non représenté sur la figure 1a. Ainsi, si le premier faisceau lumineux incident (5) frappe une partie saillante (3), le récepteur optique intercepte le deuxième faisceau lumineux réfléchi et un signal binaire « 1 » est émis dans un circuit de traitement numérique d'une carte électronique, signifiant qu'une partie saillante a bien été illuminée par le premier faisceau lumineux incident (5).

Lorsque le bouton (1) tourne autour de son axe, quelque soit le sens de rotation choisi, le premier faisceau lumineux incident (5) illumine un creux (6) situé entre deux saillies (3) consécutives et le récepteur optique n'intercepte pas le deuxième faisceau lumineux réfléchi car l'angle et/ou la profondeur dudit creux le font sortir de la zone de réception du récepteur optique. Un signal binaire « 0 » est alors émis par le circuit de traitement numérique, signifiant que le bouton (1) a tourné. En poursuivant la rotation du bouton (1) dans le même sens, le premier faisceau (5) frappe de nouveau une partie saillante (3) de la couronne (2) et un signal binaire « 1 » est alors émis dans le circuit de traitement numérique. Le dispositif fonctionne de la même manière pour toute la course du bouton rotatif (1).

Les figures 2a et 2b représentent quant à elles un système à encodeur subissant des perturbations. Un bouton rotatif (1), représenté en figure 2a, est constitué d'une couronne (2) divisée en 'n' parties saillantes (13) régulièrement espacées, dont la résolution est trop élevée pour le dispositif car les parties saillantes (13) de la couronne (2) ne sont pas suffisamment espacées les unes des autres. Les deux faisceaux lumineux (dont 5) émis par les émetteurs (dont 4) subissent un recouvrement réciproque. De ce fait, le signal électrique émis par le circuit de traitement numérique en sortie du codeur (1) n'est alors plus saturé et on obtient un signal sinusoïdal (17) dont les niveaux logiques « 1 » et « 0 » ne sont plus détectables par un processeur.

Pour résumer, lorsque la distance angulaire entre deux parties saillantes (3) est supérieure à l'angle d'incidence des faisceaux lumineux incident (5) émis, les faisceaux lumineux réfléchis ne subissent pas d'interférence lumineuse l'un par rapport à l'autre et sont interceptés dans leur intégralité par les récepteurs optiques avant que la couronne (2) n'ait effectué une autre rotation angulaire. Le signal électrique (7) émis par le circuit de traitement numérique en sortie du codeur est donc normalement saturé et on obtient un signal carré (7) dont les niveaux logiques « 1 » et « 0 » sont aisément détectables.

En revanche, si la distance angulaire séparant deux parties saillantes (13) est supérieure à l'angle d'incidence des faisceaux lumineux incidents (5) issus des émetteurs de lumière (4), comme c'est le cas sur la figure 2a, les faisceaux réfléchis ne sont pas entièrement interceptés par les récepteurs optiques, les deux faisceaux lumineux s'interfèrent et le signal émis par le circuit de traitement numérique n'est alors plus un signal saturé mais un signal sinusoïdal (17). Le processeur implanté dans la carte électronique n'est alors plus en mesure de détecter ni les états logiques « 0 » et « 1 » délivrés par le système de traitement numérique, ni le déphasage entre les signaux des deux capteurs optiques.

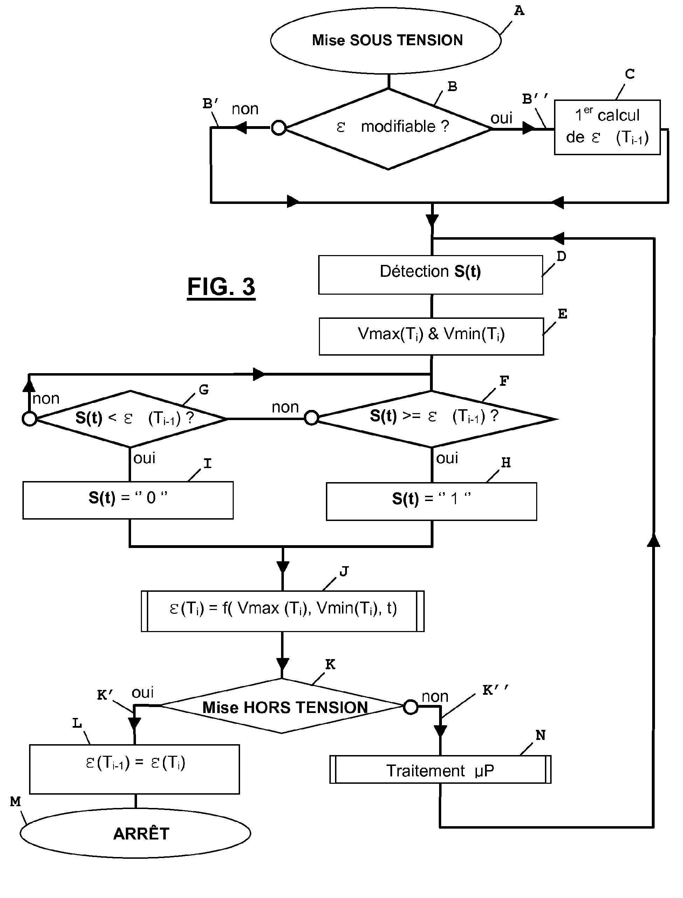

Le logigramme représenté sur la figure 3 présente l'enchaînement des étapes du procédé de l'invention : La première étape est symbolisée par l'étape (A), il s'agit du démarrage du procédé, qui correspond également à la mise sous tension du dispositif, un premier test est effectué.

Une fois le procédé mis en marche, un test (B) est effectué : soit la valeur d'un seuil ε est fixée et immuable dans une mémoire (B'), soit cette valeur seuil est modifiable (B"). Dans le cas où la variable du seuil ε est modifiable, il faut initialiser la valeur seuil au démarrage (C). Dans le cas d'un système à codeur incrémental, un premier tour de calibrage est effectué, durant lequel le récepteur du capteur détecte toutes les parties saillantes présentes sur 360° et le circuit de traitement numérique mémorise l'amplitude maximale moyenne V̅m̅a̅x̅ et l'amplitude minimale moyenne V̅m̅i̅n̅ de ce premier tour. La valeur seuil initiale ε(Tᵢ₋₁) est alors calculée à partir de la valeur de V̅m̅a̅x̅ et de la valeur de V̅m̅i̅n̅. Les étapes A à C qui viennent d'être décrites constituent le mode de calibrage (I) du processus de numérisation du signal électrique.

Une fois la valeur du seuil déterminée, le procédé et son dispositif associé entrent dans un mode de fonctionnement normal (II) dès qu'un signal électrique S(t), délivré par un générateur de signaux est détecté (D) en entrée du dispositif. Dans le cas d'un bouton rotatif, le signal S(t) est généré par le circuit de traitement du codeur incrémental. Néanmoins, le procédé et le dispositif décrit pourraient tout aussi bien traiter des signaux issus de générateurs basses fréquences, de générateurs hautes fréquences, ou de tout autre générateur de signaux analogiques ou numériques quelconque.

Une fois le signal S(t) détecté, l'amplitude maximale moyenne V̅m̅a̅x̅(Tᵢ) et l'amplitude minimale moyenne V̅m̅i̅n̅(Tᵢ) sont mesurées (E) sur une période de fonctionnement Tᵢ. Dans le dispositif de l'invention, un moyen de mesure d'amplitudes comme une interface analogique spécifique est chargée de mesurer les amplitudes maximale moyenne V̅m̅a̅x̅(Tᵢ) et minimale moyenne V̅m̅i̅n̅(Tᵢ) sur une période de fonctionnement Tᵢ.

Une fois les caractéristiques du signal S(t) connues, ce dernier est comparé avec la valeur seuil ε(Tᵢ₋₁) déterminée initialement au cours du mode de calibrage de la valeur seuil. Les tests (F et G) qui suivent et les actions qui en résultent (H et I) sont opérés par un moyen de détection « bi-niveaux » du dispositif de l'invention. Notamment ce moyen de détection peut être assuré par un capteur optique ou un capteur magnétique.

Une comparaison du signal S(t) avec la valeur seuil initiale ε(Tᵢ₋₁) permet d'identifier toutes les valeurs du signal S(t) supérieures ou égales (F) à la valeur seuil initiale ε(Tᵢ₋₁). Si les valeurs du signal S(t) sont supérieures à la valeur seuil initiale ε(Tᵢ₋₁) (H), elles sont converties en un état logique « 1 ».

Une comparaison du signal S(t) avec la valeur seuil initiale ε(Tᵢ₋₁) permet également d'identifier toutes les valeurs du signal S(t) inférieures (G) à la valeur seuil initiale ε(Tᵢ₋₁).
Si les valeurs du signal S(t) sont inférieures (I) à la valeur seuil initiale ε(Tᵢ₋₁), elles sont converties en un état logique « 0 ».

Parallèlement à la conversion du signal S(t) en une série d'impulsions S'(t), la valeur du seuil ε(Tᵢ₋₁) est recalibrée (J) périodiquement à une fréquence fᵢ=1/Tᵢ, en une valeur seuil ε(Tᵢ) à partir des valeurs de l'amplitude maximale moyenne V̅m̅a̅x̅(Tᵢ) et de l'amplitude minimale moyenne V̅m̅i̅n̅(Tᵢ).

Dans le cas d'un signal délivré par un codeur rotatif, la valeur seuil ε(Tᵢ) est calculée après « N » tours de la couronne, la valeur de « N » étant définie par l'utilisateur. Plus la valeur de « N » sera faible, plus la série d'impulsions S'(t) sera précise par rapport au signal S(t) car les valeurs des amplitudes maximale moyenne V̅m̅a̅x̅(Tᵢ) et minimale moyenne V̅m̅i̅n̅(Tᵢ), et par conséquent la valeur du seuil ε seront réactualisées fréquemment.

La fin du cycle du procédé ou la coupure du dispositif est entraînée par la mise hors tension du système (K), lorsque l'utilisateur coupe le contact du véhicule par exemple.

Dans le cas d'une mise hors tension (K'), le dernier seuil ε(Tᵢ) est sauvegardée dans une mémoire (L). Physiquement cette mémoire est une mémoire réenregistrable. On peut envisager des mémoires du type EEPROM, dans des microprocesseurs ou dans tout autre circuit logique programmable. Cette sauvegarde a lieu avant l'arrêt total du système (M).

Dans le cas où le procédé n'est pas interrompu (K''), le signal S(t) qui est alors converti en une série d'impulsions S'(t), ne possède plus que deux états logiques distincts « 0 » et « 1 » que le processeur implanté sur la carte électronique de traitement est désormais en mesure de détecter. Le processeur peut alors calculer (N) et fournir des informations sur le déplacement, la position angulaire et/ou la vitesse ainsi que le sens du bouton rotatif si le signal S(t) est issu d'un codeur incrémental ou toute autre information que le processeur programmé doit délivrer.

Le cycle de fonctionnement normal (II) commençant à partir de l'étape D, tant que le procédé n'a pas été interrompu et que le dispositif n'a pas été mis hors tension, les étapes D à K s'enchaînent successivement (O) à la fréquence fᵢ=(1/Tᵢ), 'i' étant incrémenté d'une unité à chaque nouveau cycle. Dans le cas d'un bouton rotatif, dès que la couronne dentée à effectué N tours.

Pour plus de clarté, les étapes ont été décrites de manière successive. Le rafraîchissement des données et l'actualisation du signal S' (t) se font en temps réel c'est-à-dire que la durée entre l'instant où le signal S(t) pénètre dans le dispositif de traitement de signal et l'instant où le signal S'(t) correspondant est délivré en sortie du dispositif est infime.

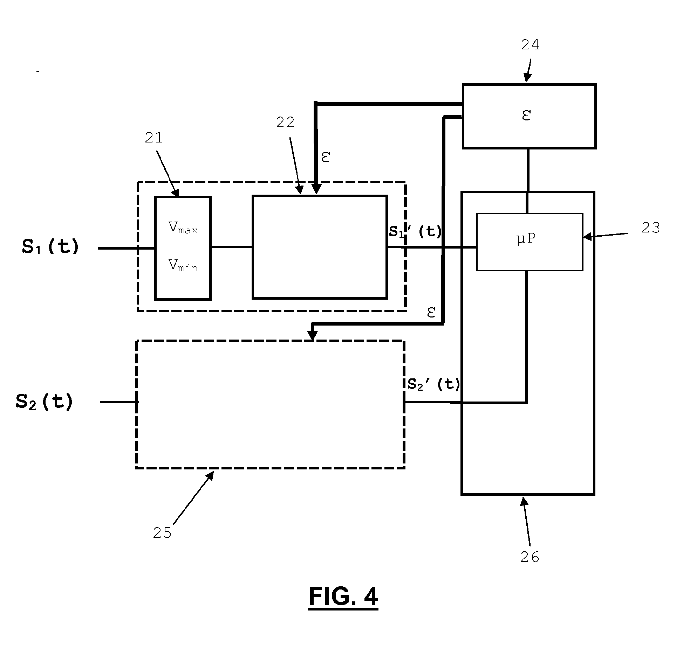

La figure 4 représente une vue schématique du dispositif de numérisation d'un signal électrique S(t) fonctionnant suivant le procédé illustré sur le logigramme de la figure 2. Le dispositif est constitué d'une interface analogique (21) chargée de mesurer les amplitudes maximale moyenne V̅m̅a̅x̅ et minimale moyenne V̅m̅i̅n̅ d'un signal S₁(t) sur une période de fonctionnement Tᵢ.
Cette interface est suivie d'un module de détection « deux niveaux » (22) qui compare la valeur du seuil ε₁ à chacune des valeurs du signal S₁(t).
Le signal S₁(t), alors converti en une série d'impulsions S₁'(t), ne possède plus que deux états logiques distincts « 0 » et « 1 » et est délivré à un processeur (23) implanté sur une carte électronique de traitement (26) qui détermine par calcul et fournit des informations sur le déplacement, la position angulaire et/ou la vitesse ainsi que le sens du bouton rotatif si le signal S₁(t) est issu d'un codeur incrémental ou toute autre information que le processeur (23) programmé doit délivrer.

Lors de l'interruption du process décrit dans l'invention, à la mise hors tension du dispositif, la dernière valeur calculée du seuil ε₁ est stockée dans une mémoire (24). Cette mémoire (24) est avantageusement une mémoire du type EEPROM mais peut tout aussi bien être un circuit logique programmable quelconque tels qu'une SRAM, une EPROM ou encore une mémoire Flash. Cette mémoire (24) fournit la valeur du seuil ε₁ lors de la mise sous tension du dispositif avant que le seuil ε₁ ne soit calibré au cours du mode calibrage (I).
L'un des intérêts de ce système est notamment qu'il permet de traiter plusieurs signaux électriques S_{λ}(t) simultanément ('λ' étant le nombre de signaux électriques traités). Dans le cas de plusieurs signaux électriques S_{λ}(t), le dispositif nécessite λ moyens de mesure des amplitudes V̅m̅a̅x̅ et V̅m̅i̅n̅ et λ moyens de détection « deux niveaux ». Le processeur (23) implanté sur une carte électronique de traitement (26) est préférentiellement unique puisque pour déterminer le sens de rotation d'un système, il lui faut comparer le déphasage entre deux signaux. En outre, pour limiter les coûts et l'encombrement du dispositif, il est possible de stocker les valeurs des seuils ε_{λ} dans une seule et même mémoire (24), néanmoins il n'est pas exclu de stocker les valeurs des seuils ε_{λ} dans des mémoires distinctes (24_{λ}). Dans le cas d'un bouton rotatif, un codeur incrémental fournit en entrée du dispositif deux signaux électriques S₁(t) et S₂(t) déphasés l'un de l'autre et numérisés simultanément. Alors que les moyens de traitement (21) et (22) sont consacrés au traitement du signal S₁(t), leur symétrique, non représentés dans le dispositif de traitement du signal (25) sont consacrés au traitement du signal S₂(t). Le déphasage entre les signaux obtenus S₁'(t) et S₂'(t) permet de déterminer le sens de rotation du bouton.

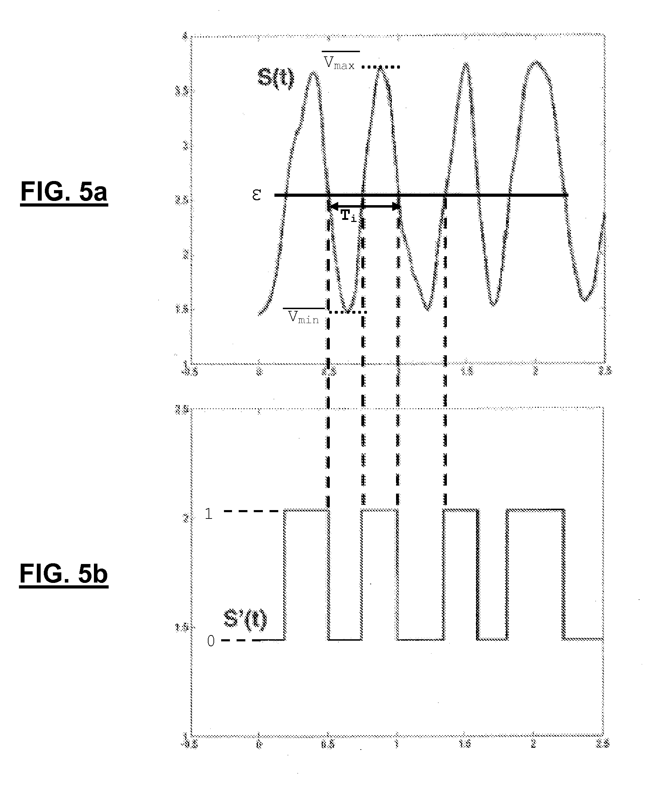

Les figures 5a et 5b illustrent une représentation graphique d'un signal électriques S(t) et du signal S'(t) obtenus à la sortie du dispositif de l'invention.
Sur la figure 5a, un signal sinusoïdal S(t) est un exemple d'un représentation graphique d'un signal obtenu en sortie d'un récepteur photosensible d'un codeur incrémental dans le cas où le faisceau émis par le récepteur est perturbé par une interférence lumineuse. Le segment de droite représenté matérialise le seuil ε calculé à partir des amplitudes V̅m̅a̅x̅ et V̅m̅i̅n̅ moyennes du signal S(t) mesurées sur un cycle de fonctionnement du procédé.

Sur la figure 5b, le signal S'(t) est le signal obtenu après traitement de S(t) par le procédé décrit dans la présente invention.

Toutes les valeurs du signal S(t) supérieures à la valeur du seuil ε ont été converties en un état logique haut tandis que toutes les valeurs du signal S(t) inférieures à la valeur du seuil ε ont été converties en un état logique bas.

Un procédé tel que celui évoqué précédemment ainsi que le dispositif mettant en oeuvre ledit procédé peuvent traiter des signaux électriques quelconques générés par n'importe quel type de générateur de signaux. Grâce à cette invention il est possible de numériser des signaux issus de codeurs rotatifs optiques, de codeurs électromécaniques, de capteurs à effet Hall auquel cas la couronne rotative de parties saillantes est remplacée par une roue présentant des pôles Nord et des pôles Sud, ainsi que tout autre capteur cinématique, générateurs basse fréquence, etc.

Bien évidemment, l'invention n'est pas limitée aux modes de réalisation décrits précédemment et fournis uniquement à titre d'exemple et englobe d'autres variantes que pourra envisager l'homme du métier dans le cadre des revendications et notamment toutes combinaisons des différents modes de réalisation décrits précédemment.

## Revendications

1. Procédé de numérisation d'un signal comprenant un cycle composé d'au moins les étapes suivantes prises successivement :
a. acquisition d'au moins un signal (S(t)) ;
b. mesure d'une amplitude maximum (Vmax(Tᵢ)) et d'une amplitude minimum (Vmin(Tᵢ)) du signal (S(t)) sur une période (Tᵢ) du signal (S(t));
c. détermination d'une valeur seuil (ε(Tᵢ)) sur une période (Tᵢ) du signal (S(t))en fonction desdites amplitudes (Vmax(Tᵢ)) et (Vmin(Tᵢ))mesurées ;
d. comparaison du signal (S(t)) avec le seuil (ε(Tᵢ)) sur une période (Tᵢ₊₁) du signal (S(t)) ;
e. conversion de toutes les valeurs du signal (S(t)) inférieures au seuil (ε(Tᵢ)) en un niveau logique « 0 » et de toutes les valeurs du signal (S(t)) supérieures ou égales au seuil (ε(Tᵢ₋₁)) en un niveau logique « 1 ».

2. Procédé selon la revendication 1, **caractérisé en ce que** la valeur du seuil (ε(Tᵢ)) est une constante stockée en mémoire.

3. Procédé selon la revendication 2, **caractérisé en ce que** lesdites amplitudes (Vmax(Tᵢ)) et (Vmin(Tᵢ)) mesurées sur une période (Tᵢ) sont stockées en mémoire.

4. Procédé selon la revendication 3, **caractérisé en ce que** le seuil (ε(Tᵢ)) est recalibré dynamiquement, à une fréquence (f), durant tout le cycle de fonctionnement.

5. Dispositif de numérisation d'un signal destiné à être placé immédiatement après au moins un générateur de signal électrique **caractérisé en ce qu'**il comprend :
a. des moyens d'acquisition d'au moins un signal (S(t)) ;
b. des moyens de mesure d'une amplitude maximum (Vmax(Tᵢ)) et d'une amplitude minimum (Vmin(Tᵢ)) du signal (S(t)) sur une période (Tᵢ) du signal (S(t));
c. des moyens de détermination d'une valeur seuil (ε(Tᵢ)) sur une période (Tᵢ) du signal (S(t))en fonction desdites amplitudes (Vmax(Tᵢ)) et (Vmin(Tᵢ))mesurées ;
d. des moyens de comparaison du signal (S(t)) avec le seuil (ε(Tᵢ)) sur une période (Tᵢ₊₁) du signal (S(t));
e. des moyens de conversion de toutes les valeurs du signal (S(t)) inférieures au seuil (ε(Tᵢ)) en un niveau logique « 0 » et de toutes les valeurs du signal (S(t)) supérieures ou égales au seuil (ε(Tᵢ) en un niveau logique « 1 ».

6. Dispositif selon la revendication 5, **caractérisé en ce que** le signal obtenu après l'étape de traitement par des moyens de conversion, est traité dans une mémoire (3) du type microcontrôleur.

7. Dispositif selon la revendication 5 ou 6, **caractérisé en ce que** le signal (S(t)) est délivré par un générateur de signaux électriques.

8. Dispositif de numérisation selon la revendication 7,
**caractérisé en ce que** le signal quelconque (S(t)) est délivré par un moyen d'encodage.

9. Dispositif selon l'une quelconque des revendications 5 à 8, **caractérisé en ce que** la valeur du seuil (ε(Tᵢ)) est stockée dans une mémoire (4) accessible en lecture.

10. Dispositif selon la revendication 9, **caractérisé en ce que** la valeur du seuil (ε(Tᵢ)) est stockée dans une mémoire (4) accessible en écriture de type EEPROM.

11. Programme d'ordinateur exécuté par un microcontrôleur implémenté au sein d'un dispositif de numérisation selon les revendications 5 à 10.

12. Dispositif d'encodage, **caractérisé en ce que** au moins deux signaux quelconque (S(t)) et (S'(t)) servant à déterminer une vitesse et/ou une position et/ou un sens de rotation sont traités au moyen du dispositif de numérisation selon les revendications 5 à 10.

13. Dispositif d'encodage selon la revendication 12,
**caractérisé en ce qu'**il comporte un codeur optique à émission et réception de lumière.

14. Dispositif d'encodage selon la revendication 13,
**caractérisé en ce que** ledit codeur optique comporte :
a. une partie mobile en rotation (2), et
b. une partie fixe comprenant au moins deux capteurs photoélectriques comportant chacun :
• un émetteur de lumière (4) formant un faisceau lumineux incident (5) en direction de la partie mobile (2), et
• un récepteur optique pour intercepter les faisceaux lumineux réfléchis par la partie mobile (2).

15. Tableau de commande, **caractérisé en ce qu'**il comprend un dispositif d'encodage selon l'une quelconque des revendications 12 à 14.
